# EUROPÄISCHE PATENTANMELDUNG

(11) **EP 2 485 259 A2**
(43) Veröffentlichungstag der Anmeldung: **08.08.2012**
(21) Anmeldenummer: 11191262.2
(22) Anmeldetag: 30.11.2011
(51) Int. Cl.: H01L 27/142

(54) **Rohmodul zur Herstellung eines Dünnschichtsolarmoduls und Dünnschichtsolarmodul**

(30) Priorität: 03.02.2011 DE 102011010131
(71) Anmelder: SCHOTT Solar AG, 55122 Mainz (DE)
(72) Erfinder: Wagner, Dr. Hermann, 07745 Jena (DE); Psyk, Walter, 81371 München (DE); Lechner, Peter, 85540 Haar (DE)

(57) **Zusammenfassung**

Die Erfindung betrifft ein Rohmodul zur Herstellung eines Dünnschichtsolarmoduls sowie ein Dünnschichtsolarmodul, wobei das Rohmodul ein Substrat, eine Frontelektrodenschicht, eine Halbleiterschicht und eine Rückelektrodenschicht umfasst, wobei die Schichten durch Strukturierungsgräben in Teilzellen separiert sind, welche in einer Verschaltungsrichtung elektrisch in Serie geschaltet sind, dadurch gekennzeichnet, dass das Rohmodul zumindest einen ersten Trennbereich zum Auftrennen des Moduls in zwei Teilmodule entlang einer ersten Trennlinie, welche in der Verschaltungsrichtung verläuft, aufweist, wobei der Trennbereich einen ersten und einen zweiten Isolierungsgraben, welche parallel zueinander beidseitig der ersten Trennlinie in der Verschaltungsrichtung verlaufen, einen dritten Isolierungsgraben, welcher sich von dem ersten Isolierungsgraben mindestens bis zu der ersten Trennlinie aber nicht bis zu dem zweiten Isolierungsgraben erstreckt, sowie einen vierten Isolierungsgraben, welcher sich vom zweiten Isolierungsgraben mindestens bis zu der Trennlinie aber nicht bis zu dem ersten Isolierungsgraben erstreckt, umfasst. Aus dem erfindungsgemäßen Rohmodul lassen sich flexibel und einfach Dünnschichtsolarmodule unterschiedlicher Abmessungen fertigen.

## Beschreibung

Die Erfindung betrifft ein Rohmodul zur Herstellung eines Dünnschichtsolarmoduls sowie ein Dünnschichtsolarmodul.

Neben Aufdachinstallationen und großflächigen Solarfeldern in Kraftwerksanwendungen werden Dünnschichtsolarmodule häufig auch in der Fassade von Gebäuden eingesetzt, wobei von gebäudeintegrierter Photovoltaik gesprochen wird. So kann ein Dünnschichtsolarmodul zum Beispiel in eine Mehrfachverglasung integriert oder auch Teil derselben sein. Im Vergleich zu einer Aufdachinstallation müssen die Solarmodule dabei in der Regel in Breite und Länge den Fassadenelementen angepasst werden, um einen möglichst großen Anteil der vorhandene Fassadenfläche nutzen zu können, und einen gleichmäßigen optischen Eindruck zu erreichen. Da die Abmessungen der Fassadenelemente in der Regel bauseitig vorgegeben sind, und auch innerhalb einer Fassade unterschiedliche Abmessungen der Fassadenelemente auftreten können, werden im Bereich der gebäudeintegrierten Photovolatik also Solarmodule mit individuell angepasster Höhe und Breite benötigt.

Dünnschichtsolarmodule sind üblicherweise gemäß Stand der Technik durch parallelversetzte Strukturierungslinien in Frontelektrodenschicht, Halbleiterschicht und Rückelektrodenschicht in streifenförmige Teilzellen unterteilt, welche in einer Verschaltungsrichtung in Serie verschaltet sind. Gemäß Stand der Technik kann eine Anpassung der Größe eines Solarmoduls in der Verschaltungsrichtung zum Beispiel im Raster der Zellbreite erfolgen, in dem das für die Fertigung des Solarmoduls verwendete Rohmodul vor der Konfektionierung senkrecht zu der Richtung der Serienverschaltung, mechanisch aufgetrennt wird. Das Auftrennen des Rohmoduls kann zum Beispiel durch Glasritzen und -brechen oder Laser-Glas-Schneiden erfolgen und die außenliegenden Teilzellen können für die Kontaktierung verwendet werden. Durch Kontaktierung mit Kontaktstreifen sowie Verkapselung wird das Rohmodul anschließend zu einem fertigen Solarmodul konfektioniert.

Senkrecht zur Verschaltungsrichtung ist die Abmessung eines Solarmoduls jedoch durch die Länge der streifenförmigen Teilzellen vorgegeben und kann nach Fertigstellung des Rohmoduls nicht mehr variiert werden. Daher müssen für Kundenaufträge, die eine Anpassung der Modulgröße in zwei Richtungen erfordern, jeweils Solarmodule mit einem den Kundenanforderungen angepassten Design erstellt und gefertigt werden. In einer hochautomatisierten Fertigung von Solarmodulen, die auf die Massenproduktion eines einzigen Modul-Typs mit vorgegebenen Abmessungen und vorgegebenem Design optimiert ist, lassen sich verschiedene Modultypen und insbesondere individuelle Kleinserien jedoch nur mit hohem personellen Aufwand und Risiko herstellen. Desweiteren entsteht hoher zusätzlicher Aufwand, da für jeden Solarmodultyp ein Design entwickelt und Rezepte, Arbeitspläne, Datenblätter und Prüfanweisungen erstellt werden müssen.

Ein weiterer Nachteil ist darin zu sehen, dass die Fertigung entsprechender kundenspezifischer Solarmodule viel Zeit in Anspruch nimmt, da zuerst kundenspezifische Rohmodule gefertigt und anschließend zu Solarmodulen konfektioniert werden müssen.

Die Aufgabe der Erfindung besteht darin, die Nachteile des Standes der Technik zu überwinden und eine flexible Herstellung von Dünnschichtsolarmodulen mit variablen Abmessungen bei möglichst geringem Fertigungsaufwand zu ermöglichen.

Die Aufgabe wird gelöst durch die unabhängigen Ansprüche, bevorzugte Ausführungsformen sind in den abhängigen Ansprüchen ausgeführt.

Erfindungsgemäß wird ein Rohmodul zur Herstellung eines Dünnschichtsolarmoduls bereitgestellt, umfassend ein Substrat und ein auf dem Substrat angeordnetes Schichtsystem, welches eine Frontelektrodenschicht, eine Halbleiterschicht und eine Rückelektrodenschicht umfasst, wobei die Schichten durch Strukturierungsgräben in Teilzellen separiert sind und wobei die Teilzellen in einer Verschaltungsrichtung R elektrisch in Serie geschaltet sind.

Das erfindungsgemäße Rohmodul ist dadurch gekennzeichnet, dass das Rohmodul zumindest einen ersten Trennbereich zum Auftrennen des Moduls in zwei Teilmodule entlang einer ersten Trennlinie, welche in der Verschaltungsrichtung R verläuft, aufweist, wobei der erste Trennbereich einen ersten und einen zweiten Isolierungsgraben umfasst, welche parallel zueinander und beidseitig der ersten Trennlinie in der Verschaltungsrichtung R verlaufen, einen dritten Isolierungsgraben, welcher sich von dem ersten Isolierungsgraben mindestens bis zu der ersten Trennlinie aber nicht bis zu dem zweiten Isolierungsgraben erstreckt, und einen vierten Isolierungsgraben, welcher sich vom zweiten Isolierungsgraben mindestens bis zu der ersten Trennlinie aber nicht bis zu dem ersten Isolierungsgraben erstreckt. Der dritte und vierte Isolierungsgraben verlaufen dabei vorzugsweise senkrecht zur Verschaltungsrichtung R.

Solange das Rohmodul nicht entlang der ersten Trennlinie aufgetrennt ist, ist der Bereich zwischen dem ersten und zweiten Isolierungsgraben photovoltaisch aktiv, und kann zur Stromerzeugung des Rohmoduls beitragen. Das wird dadurch erreicht, dass der erzeugte Strom im Bereich des dritten und vierten Isolierungsgrabens jeweils um den dritten und vierten Isolierungsgraben herum, also jeweils über den nicht unterbrochenen Bereich auf der anderen Seite der Trennlinie fließen kann. Die gesamte Zellfläche des unzertrennten Rohmoduls kann also genutzt werden. Wird das Rohmodul hingegen entlang der ersten Trennlinie in zwei Teilmodule aufgetrennt, so bewirken der dritte und der vierte Isolierungsgraben jeweils eine Unterbrechung der Serienverschaltung der Teilzellen, so dass auf dem einen Teilmodul der zwischen dem ersten Isolierungsgraben und der ersten Trennlinie liegende Bereich nicht mehr photovoltaisch aktiv ist und auf dem anderen Teilmodul der zwischen dem zweiten Isolierungsgraben und der ersten Trennlinie liegende Bereich nicht mehr photovoltaisch aktiv ist. Die Auftrennung des Zellstreifens am Modulrand, die für die weitere Verschaltung benötigt wird, erfolgt also besonders vorteilhaft automatisch durch den Prozess des mechanischen Auftrennens des Rohmoduls in zwei Teilmodule. Das erfindungsgemäße Rohmodul kann zu einem Dünnschichtsolarmodul mit einer dem Rohmodul entsprechenden Fläche oder durch Auftrennen entlang der ersten Trennlinie zu einem kleinflächigeren Dünnschichtsolarmodul verarbeitet werden, wobei allein durch das mechanische Auftrennen des Rohmoduls auf den Teilmodulen Randbereiche entstehen, welche photovoltaisch inaktiv sind. Das erfindungsgemäße Rohmodul weist also ein universelles und besonders funktionelles Design auf.

Unter dem Rohmodul zur Herstellung eines Dünnschichtsolarmoduls ist das Zwischenprodukt eines mit den photovoltaischen Funktionsschichten versehenen Substrates zu verstehen, wobei die photovoltaischen Funktionsschichten in der Regel durch parallel verlaufende Strukturierungslinien in Teilzellen unterteilt und in Serie verschaltet sind. Ein Rohmodul ist jedoch noch nicht mit elektrischen Verbindungsmitteln kontaktiert und noch nicht verkapselt. Die Unterteilung der photovoltaischen Schichten in Teilzellen sowie deren Serienverschaltung durch Strukturierungslinien sowie Verfahren zum Erzeugen derartiger Strukturierungslinien sind dem Fachmann bekannt und sind im Rahmen der vorliegenden Erfindung von untergeordneter Bedeutung. Auf eine detaillierte Darstellung wird daher verzichtet.

Die Erfindung betrifft Rohmodule für verschiedenste Arten von Dünnschichtsolarmodulen. Zum Beispiel kann das Rohmodul eine Superstratkonfiguration aufweisen, wobei die einfallende Lichtstrahlung durch ein transparentes Substrat in die photovoltaischen Schichten einfällt. Ebenso kann es sich um eine Substratkonfiguration handeln, wobei die Lichtstrahlung von der dem Substrat gegenüberliegenden Seite in die photovoltaischen Schichten einfällt. Dementsprechend kann es sich bei dem Substrat um ein transparentes Substrat zum Beispiel aus Glas oder Kunststoff handeln oder auch um opake Substrate. Das Substrat kann in Form einer Platte oder einer flexiblen Folie vorliegen. Bevorzugt weist das erfindungsgemäße Rohmodul eine Superstratkonfiguration auf, wobei als Substrat eine Glasscheibe mit einer Dicke von 1 mm bis 10 mm verwendet wird.

Die Frontelektrodenschicht kann beispielsweise eine metallische Schicht oder bevorzugt eine TCO- Schicht (transparent conductive oxide) aus einem transparenten, leitfähigen Oxid wie zum Beispiel ZnO:Al oder SnO₂:F sein.

Die Halbleiterschicht kann aus verschiedenen Halbleitermaterialien wie zum Beispiel Si, Ge, CIGS (Cu-In-Ga-S/Se), Cd-Te oder Kombinationen daraus bestehen. Sie kann ferner eine p-n oder p-i-n-Struktur oder mehrere übereinander liegende Teilzellen mit p-n und/oder p-i-n-Struktur aufweisen. Bevorzugt handelt es sich um eine a-Si-Zelle (amorphes Silizium) oder um eine a-Si/a-Si oder a-Si/µc-Si-Tandemzelle.

Die Rückelektrodenschicht kann beispielsweise ebenso wie die Frontelektrodenschicht eine TCO- Schicht aus einem transparenten, leitfähigen Oxid (TCO) wie zum Beispiel ZnO:Al oder SnO₂:F, eine metallische Schicht oder eine Mehrschichtsystem aus TCO-Schichten und metallischen Schichten sein.

Es können ferner weitere Schichten auf dem Substrat angeordnet sein, wie zum Beispiele Reflektorschichten, Barriereschichten, welche die Vermischung von aneinandergrenzenden Schichten z.B. durch Diffusion verhindern, sowie Haftschichten, welche den mechanischen Zusammenhalt des Schichtsystems verbessern. Insbesondere kann zwischen Substrat und Frontelektrodenschicht eine strukturierte Schicht, angeordnet sein, um die Lichteinfangeigenschaften des Solarmoduls zu verbessern

Dem Fachmann ist klar, dass das erfindungsgemäße Prinzip sich auf jede auf einem flächigen Substrat vorliegende Dünnschichtsolarzelle anwenden lässt, so dass die genannten Ausführungsformen des Rohmoduls und seiner Bestandteile lediglich als Beispiele zu verstehen sind.

Unter einem Trennbereich ist jeweils der Flächenbereich des Rohmoduls zwischen dem ersten und zweiten Isolierungsgraben dieses Trennbereiches zu verstehen, welcher sich in der Verschaltungsrichtung streifenförmig über das Rohmodul erstreckt.

Die Trennlinie stellt lediglich eine fiktive Linie dar, entlang der das Rohmodul potentiell mechanisch aufgebrochen werden kann. Sie verläuft zwischen dem ersten und zweiten Isolierungsgraben, in welchen das Schichtsystem abgetragen ist und parallel zu diesen. In der Trennlinie selbst muss jedoch keine der Funktionsschichten abgetragen sein.

Der erste und zweite sowie der dritte und vierte Isolierungsgraben sind jeweils in Form einer Aussparung in dem Schichtsystem ausgeführt, welche zumindest die Funktionsschichten Frontelektrode, Halbleiterschicht und Rückelektrodenschicht umfassen. Dem Fachmann sind sowohl mechanische als auch Laser-basierte Verfahren zum Einbringen des umlaufenden Isolierungsgrabens bekannt, welche auch zum Einbringen dieser Isolierungsgräben zum Einsatz kommen können.

Im Folgenden werden bevorzugte Ausführungsformen der Erfindung näher erläutert. Die erste Trennlinie verläuft bevorzugt mittig zwischen dem ersten und zweiten Isolierungsgraben, und die beiden kurzen Isolierungsgräben verlaufen senkrecht zu der ersten Trennlinie. Liegt die erste Trennlinie mittig zwischen dem ersten und zweiten Isolierungsgraben, so werden durch die Auftrennung des Rohmoduls entlang der ersten Trennlinie zwei Teilmodule erhalten, welche photovoltaisch inaktive Randstreifen gleicher Breite aufweisen. Die erste Trennlinie kann jedoch von der Mitte aus auch zu dem ersten oder zweiten Isolierungsgraben hin verschoben sein, wobei der dritte und vierte Isolierungsgraben dann vorzugsweise in der Länge angepasst sind. Der dritte und vierte Isolierungsgraben verlaufen bevorzugt senkrecht zu dem ersten und zweiten Isolierungsgraben. Desweiteren verlaufen der dritte und vierte Isolierungsgraben bevorzugt in dem Übergangsbereich zwischen einem benachbarten Paar von serienverschalteten Teilzellen, wodurch die Isolierungsgräben optisch unauffällig ausgeführt werden können.

Der erste Trennbereich umfasst bevorzugt weitere Isolierungsgräben, welche sich jeweils von dem ersten oder dem zweiten Isolierungsgraben mindestens bis zu der ersten Trennlinie, aber nicht bis zu dem jeweils anderen des ersten und zweiten Isolierungsgrabens erstrecken, also entsprechend dem dritten und vierten Isolierungsgraben ausgebildet sind. Durch diese weiteren Isolierungsgräben wird der zwischen dem ersten Isolierungsgraben und der ersten Trennlinie liegende Randbereich nach mechanischem Auftrennen an mehreren Stellen elektrisch unterbrochen und ist abschnittweise komplett von den Kontaktierungssegmenten des Rohmoduls elektrisch isoliert. Durch entsprechende Positionierung zumindest zweier Isolierungsgräben auf gegenüberliegenden Seiten des Rohmoduls kann nahezu der gesamte Randbereich des Teilmoduls elektrisch isoliert werden, so dass ein umlaufender isolierter Rand entsteht. Desweiteren kann durch mehrere Unterbrechungen des Randbereiches die Entstehung von hohen Spannungen vermieden werden, da auch die nicht verschalteten Zellbereiche bei Lichtfall entsprechende Spannungen aufbauen können.

Das Rohmodul umfasst bevorzugt einen umlaufenden Isolierungsgraben in Form einer Aussparung in dem Schichtsystem, welcher sich entlang des Modulrandes umlaufend erstreckt und eine aktive Modulfläche und einen Randbereich elektrisch voneinander isoliert. Der umlaufende Isolierungsgraben wird benötigt, um die spannungsführenden Bereiche des Rohmoduls gegenüber seiner Umgebung elektrisch zu isolieren. Der umlaufende Isolierungsgraben umfasst zumindest die Frontelektrodenschicht, die Rückelektrodenschicht und die Halbleiterschicht. Er kann in seiner Struktur dem Strukturierungsgraben in dem Trennbereich entsprechen und auch mit denselben Mitteln in das Schichtsystem eingebracht werden, die dem Fachmann bekannt sind. In dem außen liegenden Randbereich kann das Schichtsystem von dem Substrat abgetragen sein, was insbesondere vorteilhaft ist, wenn das Dünnschichtsolarmodul durch Auflaminieren einer Folie verkapselt werden soll. Dafür können so genannte Randentschichtungsverfahren zum Einsatz kommen, die dem Fachmann bekannt sind.

Der erste und zweite Isolierungsgraben des ersten Trennbereiches erstrecken sich bevorzugt über die gesamte Modullänge in Verschaltungsrichtung oder zumindest bis zu dem umlaufenden Isolierungsgraben, so dass die aktive Modulfläche in elektrisch voneinander isolierte Teilbereiche aufgeteilt wird.

In einer bevorzugten Ausführungsform umfasst das Rohmodul weitere Trennbereiche mit einer Struktur gemäß dem ersten Trennbereich, wobei die Trennlinien dieser weiteren Trennbereiche parallel zu der ersten Trennlinie angeordnet sind. Weiterhin bevorzugt sind die Trennbereiche in einem regelmäßigen Abstand d₂ angeordnet, und der Abstand d₂ beträgt von 10 mm bis 500 mm und bevorzugt 50 mm bis 300 mm. Die Abmessung eines derartigen Rohmoduls kann durch mechanisches Auftrennen entlang einer der Trennlinien der Trennbereiche also schrittweise angepasst werden.

Der Abstand des ersten und zweiten Isolierungsgrabens eines Trennbereiches beträgt bevorzugt jeweils 0,5 mm bis 100 mm, und besonders bevorzugt 4 mm bis 50 mm. Der Abstand des ersten und zweiten Isolierungsgrabens sollte nach dem Auftrennen entlang der Trennlinie auf beiden erzeugten Teilmodulen einem Randbereich ausreichender Breite entsprechen. Des Weiteren sind die Positioniergenauigkeit sowie die Schnittbreite beim mechanischen Auftrennen des Rohmoduls zu berücksichtigen. Des Weiteren weisen der erste und zweite Isolierungsgraben eines Trennbereiches bevorzugt jeweils den gleichen Abstand d₁ auf. Das Verhältnis von d₂ zu d₁ beträgt von 2 bis 50 und bevorzugt von 10 bis 30.

In einer bevorzugten Ausführungsform handelt es sich bei dem Rohmodul um ein semitransparentes Rohmodul, welches Transparenzöffnungen in Form von Aussparungen in der Rückelektrodenschicht und der Halbleiterschicht aufweist, so dass ein Teil des auf das Rohmodul fallenden Lichtes durch die Transparenzöffnungen transmittiert werden kann. Semitransparente Dünnschichtsolarmodule kommen insbesondere in der gebäudeintegrierten Photovoltaik zum Einsatz, wo eine Teilmenge der einfallenden Lichtstrahlung für Beleuchtungszwecke in dem Gebäude verwendet werden soll. Die Transparenzöffnungen bestehen wie die Isolierungsgräben in Aussparungen in dem Schichtsystem. Im Gegensatz zu den Isolierungsgräben, wo zumindest Frontelektrodenschicht, Halbleiterschicht und Rückelektrodenschicht abgetragen sind, sind in den Transparenzöffnungen die Rückelektrodenschicht und bevorzugt auch die Halbleiterschicht abgetragen. Dem Fachmann sind Möglichkeiten zum Erzeugen derartiger Transparenzöffnungen z.B. basierend auf Laserabtragsverfahren, Liftoff-Verfahren und Ähnliches bekannt. Neben den Abtragsverfahren besteht prinzipiell auch die Möglichkeit, die Transparenzöffnungen beim Auftragen des Schichtsystems direkt auszusparen, was zum Beispiel mit Hilfe von Drucktechniken möglich ist. Der relative Flächenanteil der Transparenzöffnungen an der gesamten Modulfläche beträgt in der Regel zwischen 5 % und 50 %. Der Transmissionsgrad des Rohmoduls in den Transparenzöffnungen beträgt typischerweise zwischen 10 % und 90 %, so dass eine Teilmenge der einfallenden Lichtstrahlung für Beleuchtungszwecke hindurch gelassen wird.

Die Transparenzöffnungen sind bevorzugt in Form von parallel in der Verschaltungsrichtung R verlaufenden Transparenzgräben ausgebildet und in einem regelmäßigen Abstand d₃ angeordnet und verlaufen damit parallel zur Stromflussrichtung, was sich positiv auf die elektrischen Eigenschaften des Solarmoduls auswirkt. Die Transparenzgräben umfassen bevorzugt eine Aussparung in der Rückelektrodenschicht sowie eine Aussparung in der Halbleiterschicht, wobei die Aussparung in der Halbleiterschicht mit etwas geringerer Breite als die Aussparung in der Halbleiterschicht ausgeführt sein kann, wodurch die Gefahr von Kurzschlüssen zwischen Frontelektrodenschicht und Rückelektrodenschicht im Bereich der Ränder der Transparenzgräben reduziert werden kann.

Der Abstand des ersten und zweiten Isolierungsgrabens eines Trennbereiches d₂ entspricht bevorzugt einem Vielfachen des Abstandes der Transparenzgräben d₃, wobei der erste und zweite Isolierungsgraben eines Trennbereiches jeweils innerhalb eines Transparenzgrabens angeordnet sind. Die innerhalb der Transparenzgräben angeordneten Isolierungsgräben sind optisch unauffällig platziert. Desweiteren muss innerhalb der Transparenzgräben nur noch die verbliebene Frontelektrode durchtrennt werden. Die Aussparung in der Frontelektrodenschicht, die zum Beispiel mit einem Laser eingebracht werden kann, weist bevorzugt eine geringere Breite als die Aussparungen in Halbleiterschicht und Rückelektrodenschicht auf. Besonders bevorzugt entspricht der Abstand d₂ dem doppelten Wert des Abstandes der Transparenzgräben d₃, d.h. die Trennlinie des semitransparenten Rohmoduls verläuft in einem Transparenzgraben, und in den beidseitig benachbarten Transparenzgräben verlaufen der erste und der zweite Isolierungsgraben.

In einer weiteren bevorzugten Ausführungsform weist das Rohmodul komplementäre Transparenzgräben in Form von Aussparungen in der Rückelektrodenschicht und der Halbleiterschicht auf, welche senkrecht zur Verschaltungsrichtung verlaufen und jeweils im Übergangsbereich zwischen zwei serienverschalteten Teilzellen ausgebildet sind. Derartige komplementäre Transparenzgräben sind zum Beispiel bekannt aus der DE 69228079 T2, Seite 14 sowie Figuren 10 und 11. Auch Verfahren zum Einbringen dieser komplementären Transparenzgräben sind dem Fachmann geläufig. Im Vergleich zu den in Verschaltungsrichtung verlaufenden Transparenzgräben sind die komplementären Transparenzgräben bevorzugt in den Übergangsbereichen zwischen den serienverschalteten Teilzellen angeordnet und ersetzen vorteilhaft gleichzeitig die Strukturierungslinie in der Rückelektrodenschicht.

Bevorzugt umfasst das Rohmodul ferner Kontaktierungsbereiche, welche auf der ersten und letzten serienverschalteten Teilzelle eines jeden Teilbereiches angeordnet sind. Diese Zellen werden auch als Abgriffzellen bezeichnet. Sofern die Rückelektrodenschicht aus einer Metallschicht besteht, kann die Kontaktierung der ersten und letzten Teilzellen direkt auf der Rückelektrodenschicht erfolgen. Es können aber in den Kontaktierungsbereichen auch weitere Schichten auf der Rückelektrodenschicht angeordnet sein, zum Beispiel eine Nickel-Vanadium-Schicht, welche eine Schädigung der Kontaktierungsbereiche der Dünnschichtzelle verhindert.

Die Erfindung betrifft des Weiteren ein Dünnschichtsolarmodul, welches ein erfindungsgemäßes Rohmodul umfasst. So kann ein Dünnschichtsolarmodul ein einziges erfindungsgemäßes Rohmodul oder auch ein Teilmodul eines erfindungsgemäßen Rohmoduls umfassen, welches beispielsweise entlang einer Trennlinie mechanisch aufgetrennt ist. Desweiteren kann ein erfindungsgemäßes Rohmodul auch in Verschaltungsrichtung gekürzt werden.

Ebenso kann ein erfindungsgemäßes Dünnschichtsolarmodul ein erstes Rohmodul sowie zumindest ein erstes Teilmodul eines weiteren Rohmoduls umfassen, wobei das erste Teilmodul durch Auftrennen des weiteren Rohmoduls entlang einer Trennlinie erhalten werden kann, und wobei das erste Rohmodul ein erstes Teilmodul aufweist, welches baugleich mit dem ersten Teilmodul ausgebildet ist. Dadurch können auch Module mit einer größeren Fläche als der des Rohmoduls hergestellt werden.

Bevorzugt werden das erste Rohmodul und das erste Teilmodul so nebeneinander angeordnet, dass der optische Eindruck eines einzigen Rohmoduls entsteht, welches eine größere Fläche als das erste Rohmodul aufweist. Aufgrund der randisolierten Bereiche des ersten Rohmoduls und des ersten Teilmoduls kann es dabei nicht zu unerwünschten Kurzschlüssen in dem Bereich kommen, wo die Module aneinander stoßen.

Bevorzugt umfasst ein derartiges erfindungsgemäßes Dünnschichtsolarmodul ferner metallische Kontaktierungsstreifen, wobei die Kontaktierungsbereiche der Bereiche des ersten Rohmoduls innerhalb der umlaufenden Isolierungslinie und die Kontaktierungsbereiche der Bereiche des ersten Teilmoduls innerhalb der umlaufenden Isolierungslinie und innerhalb der Trennlinie durch eine elektrisch leitfähige Verbindung mit dem Kontaktierungsstreifen kontaktiert sind und die Bereiche außerhalb des umlaufenden Isolierungsgrabens und der Trennlinie nicht kontaktiert sind, wodurch die Randbereiche von erstem Rohmodul und erstem Teilmodul als isolierende Randstreifen wirken.

Die Erfindung wird im Folgenden beispielhaft an den folgenden Figuren erläutert:
Figur 1: Aufsicht und Querschnittsansicht eines erfindungsgemäßen Rohmoduls
Figur 2: Aufsicht und Querschnittsansicht einer semitransparenten Ausführungsform eines erfindungsgemäßen Rohmoduls
Figur 3: Aufsicht und Querschnittsansicht eines semitransparenten Rohmoduls und eines weiteren Teilmoduls

Die Figuren stellen schematische Darstellungen dar, die nicht maßstäblich sind und lediglich der Erläuterung der Erfindung dienen. Insbesondere wurde aus Gründen der Übersichtlichkeit auf eine Darstellung der Strukturierungslinien verzichtet, welche der Aufteilung des Schichtsystems in Teilzellen und deren Serienverschaltung dienen. Aus dieser Serienverschaltung ergibt sich auch die Verschaltungsrichtung R, die im Randbereich der Abbildung mit einem Richtungspfeil dargestellt ist.

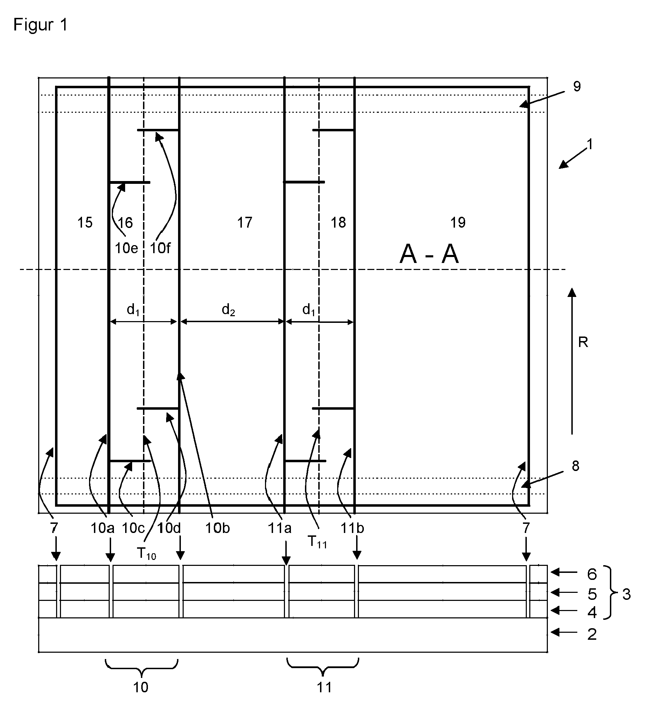

Die obere Teilfigur in Figur 1 zeigt schematisch ein erfindungsgemäßes Rohmodul (1) mit einer Schnittebene A-A senkrecht zur Verschaltungsrichtung R. Die untere Teilfigur in Figur 1 zeigt einen schematischen Querschnitt in dieser Schnittebene A-A, wobei das auf dem Substrat (2) angeordnete Schichtsystem (3) mindestens eine Frontelektrodenschicht (4), eine Halbleiterschicht (5) und eine Rückelektrodenschicht (6) aufweist. Das Schichtsystem ist durch die Isolierungsgräben (10a, 10b, 11a, 11 b) unterbrochen und in elektrisch voneinander isolierte Teilbereiche (15, 16, 17, 18, 19) unterteilt, wobei es zum einen die umlaufende Isolierungslinie (7) sowie die Isolierungslinien der Trennbereiche (10,11) gibt. In der Aufsicht sind exemplarisch zwei Trennbereiche (10, 11) dargestellt, in welchen das Rohmodul (1) jeweils entlang einer Trennlinie (T₁₀, T₁₁) getrennt werden kann. In dem ersten Trennbereich (10) sind ein erster Isolierungsgraben (10a) und ein zweiter Isolierungsgraben (10b) in Verschaltungsrichtung angeordnet, zwei Isolierungsgräben (10c, 10e), welche sich von dem ersten Isolierungsgraben (10a) bis zur Trennlinie (T₁₀) erstrecken, sowie zwei Isolierungsgräben (10d, 10f), welche sich von dem zweiten Isolierungsgraben (10b) bis zur Trennlinie (T₁₀) erstrecken. In dem Trennbereich (10) kann der Strom jeweils um die kurzen Trennlinienabschnitte (10c, 10d, 10e, 10f) herum fließen, solange das Rohmodul (1) nicht entlang der Trennlinie (T₁₀) aufgetrennt ist. Bei Auftrennung des Rohmoduls entlang der Trennlinie unterbrechen die kurzen Isolierungsgräben hingegen den Stromfluss, so dass der Bereich zwischen erstem Isolierungsgraben (10a) und Trennlinie durch das mechanische Auftrennen zu einem isolierten Randbereich wird. Erster und zweiter Isolierungsgraben sind jeweils in einem Abstand d₁ angeordnet, die Trennbereiche sind in einem Abstand d₂ angeordnet. Typischerweise ist der Abstand d₁ deutlich kleiner als der Abstand d₂, was in der nicht maßstäblichen Darstellung lediglich qualitativ angedeutet ist.

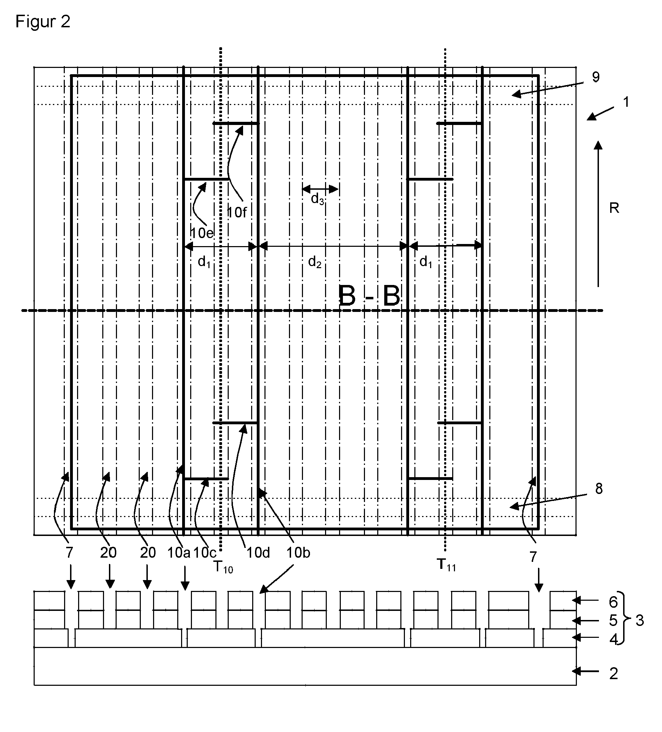

In der Figur 2 ist ein semitransparentes, erfindungsgemäßes Rohmodul dargestellt. Ergänzend zu den anhand von Figur 1 erläuterten Strukturen weist das semitransparente Rohmodul (1) Transparenzgräben (20) in Verschaltungsrichtung R auf, in welchen zumindest die Rückelektrodenschicht (6), bevorzugt auch die Halbleiterschicht (5) ausgespart ist, wie in der Querschnittsdarstellung zu erkennen ist. Der Abstand des ersten (10a) und zweiten Isolierungsgrabens (10b) entspricht gerade dem doppelten Abstand der Transparenzgräben d₃ und die Isolierungsgräben (10a, 10b) sind innerhalb der Transparenzgräben angeordnet, so dass die Trennlinie (T₁₀) gerade innerhalb des mittigen Transparenzgrabens verläuft. Entsprechend wird genau ein zwischen zwei Transparenzgräben angeordneter Bereich beim mechanischen Auftrennen des Rohmoduls entlang der Trennlinie zum isolierten Randbereich. Senkrecht zu den dargestellten Transparenzgräben können außerdem komplementäre Transparenzgräben angeordnet sein, welche jedoch aus Gründen der Übersichtlichkeit ebenso wie die Strukturierungslinien nicht dargestellt sind.

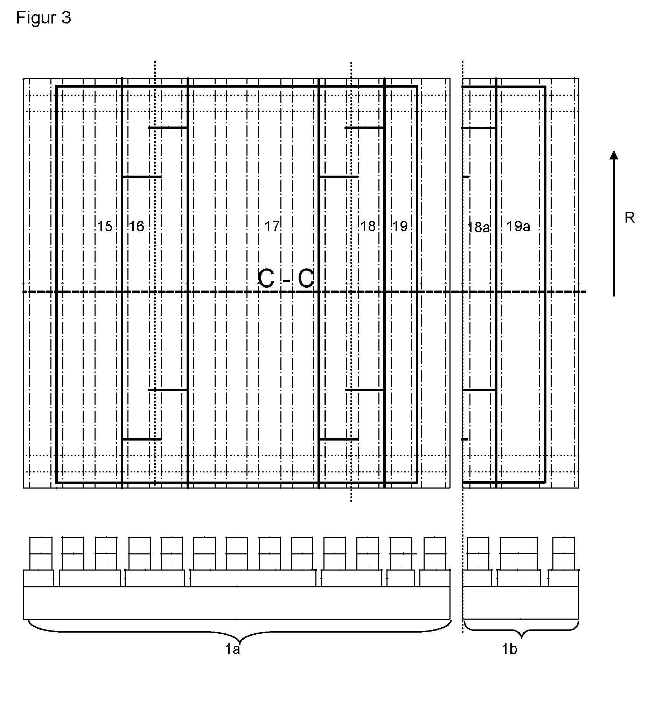

Figur 3 zeigt ein erfindungsgemäßes semitransparentes erstes Rohmodul (1a), sowie ein Teilmodul (1 b) eines weiteren gleichartigen Rohmoduls, welches entlang einer Trennlinie aufgetrennt und neben dem ersten Rohmodul (1a) so angeordnet ist, dass ein großflächiges Solarmodul entsteht.

Das erfindungsgemäße Rohmodul ist sehr flexibel zu Dünnschichtsolarmodulen unterschiedlicher Länge und Breite verarbeitbar, da es zusätzlich zu der aus dem Stand der Technik bekannten Anpassung in Richtung der Serienverschaltung jeweils in den Trennbereichen aufgetrennt werden kann und dadurch in beiden Dimensionen in der Größe angepasst werden kann. Die maximal mögliche Zellfläche wird photovoltaisch genutzt, so dass das teilbare Rohmodul zum einen ein vollwertiges Rohmodul für ein Dünnschichtsolarmodul darstellt, welches genau ein Rohmodul umfasst.

Werden hingegen Dünnschichtsolarmodule anderer Größen benötigt, kann durch das Auftrennen eines erfindungsgemäßen Rohmoduls ein kleineres Teilmodul erhalten werden, welches durch das mechanische Auftrennen entlang einer Trennlinie direkt einen isolierten Randbereich aufweist, so dass auf das Einbringen eines weiteren Isolierungsgraben verzichtet werden kann. Es muss also lediglich noch die elektrische Kontaktierung sowie eine Verkapselung des Rohmodules erfolgen.

Das erfindungsgemäße Rohmodul ist daher universell einsetzbar und ersetzt sowohl ein Standard-Rohmodul für ein Dünnschichtsolarmodul mit genau einem Rohmodul als auch spezifische Rohmodule für die Herstellung eines Dünnschichtsolarmodules mit angepassten Abmessungen.

Die erfindungsgemäßen Rohmodule können auf Vorrat hergestellt und bevorratet werden, da Sie flexibel zu Dünnschichtsolarmodulen mit kundenspezifischen Abmessungen weiterverarbeitbar sind. Dünnschichtsolarmodule mit kundenspezifischen Abmessungen können entsprechend deutlich schneller gefertigt werden, als es der Fall ist, wenn das Design des Rohmoduls angepasst werden muss und erst entsprechende kundenspezifische Rohmodule gefertigt werden müssen.

### Bezugszeichenliste:

- 1: Rohmodul
- 1a: erstes Rohmodul
- 1b: Teilmodul
- 2: Substrat
- 3: Schichtsystem
- 4: Frontelektrodenschicht
- 5: Halbleiterschicht
- 6: Rückelektrodenschicht
- 7: umlaufender Isolierungsgraben
- 8: Kontaktierungssegment auf erster Teilzelle
- 9: Kontaktierungssegment auf letzter Teilzelle
- 10: erster Trennbereich
- 10 a,b: erster, zweiter Isolierungsgraben
- 10 c,d: dritter, vierter Isolierungsgraben
- 11,12: weitere Trennbereiche
- 15...19: elektrisch isolierte Teilbereiche des Moduls
- 20: Transparenzgraben
- R: Verschaltungsrichtung
- T₁₀: erste Trennlinie

## Patentansprüche

1. Rohmodul zur Herstellung eines Dünnschichtsolarmoduls umfassend ein Substrat (2) und ein auf dem Substrat angeordnetes Schichtsystem (3), welches eine Frontelektrodenschicht (4), eine Halbleiterschicht (5) und eine Rückelektrodenschicht (6) umfasst, wobei die Schichten (4, 5, 6) durch Strukturierungsgräben in Teilzellen separiert sind, welche in einer Verschaltungsrichtung R elektrisch in Serie geschaltet sind,
**dadurch gekennzeichnet,**
**dass** das Rohmodul (1) zumindest einen ersten Trennbereich (10) zum Auftrennen des Rohmoduls (1) in zwei Teilmodule entlang einer ersten Trennlinie (T₁₀), welche in der Verschaltungsrichtung R verläuft, aufweist, wobei der erste Trennbereich (10) umfasst
einen ersten (10a) und einen zweiten (10b) Isolierungsgraben, welche parallel zueinander und beidseitig der ersten Trennlinie (T₁₀) in der Verschaltungsrichtung R verlaufen, einen dritten Isolierungsgraben (10c), welcher sich von dem ersten Isolierungsgraben (10a) mindestens bis zu der ersten Trennlinie (T₁₀) aber nicht bis zu dem zweiten Isolierungsgraben (10b) erstreckt, und einen vierten Isolierungsgraben (10d), welcher sich vom zweiten Isolierungsgraben (10b) mindestens bis zu der ersten Trennlinie (T₁₀) aber nicht bis zu dem ersten Isolierungsgraben (10a) erstreckt.

2. Rohmodul nach Anspruch 1, wobei die erste Trennlinie (T₁₀) mittig zwischen dem ersten (10a) und zweiten (10b) Isolierungsgraben verläuft, und der dritte (10c) und vierte (10d) Isolierungsgraben senkrecht zu der Verschaltungsrichtung R verlaufen.

3. Rohmodul nach den vorhergehenden Ansprüchen, wobei der erste Trennbereich (10) weitere Isolierungsgräben (10e, 10f) umfasst, welche sich jeweils von dem ersten (10a) oder zweiten (10b) Isolierungsgraben mindestens bis zu der ersten Trennlinie (T₁₀), aber nicht bis zu dem jeweils anderen des ersten und zweiten Isolierungsgrabens (10b, 10a) erstrecken.

4. Rohmodul nach den vorhergehenden Ansprüchen, ferner umfassend einen umlaufenden Isolierungsgraben (7) in Form einer Aussparung in dem Schichtsystem (3), welcher sich entlang des Modulrandes umlaufend erstreckt und eine aktive Modulfläche und einen Randbereich elektrisch voneinander isoliert.

5. Rohmodul nach den vorhergehenden Ansprüchen, wobei der erste (10a) und der zweite Isolierungsgraben (10b) des ersten Trennbereiches (10) sich über die gesamte Modullänge in Verschaltungsrichtung R erstrecken oder zumindest bis zu dem umlaufenden Isolierungsgraben (7), so dass die aktive Modulfläche in elektrisch voneinander isolierte Teilbereiche (15, 16, 17, 18, 19) aufgeteilt wird.

6. Rohmodul nach den vorhergehenden Ansprüchen, wobei das Rohmodul (1) weitere Trennbereiche (11) mit einer Struktur gemäß dem ersten Trennbereich (10) umfasst, wobei die Trennlinien (T₁₁) dieser weiteren Trennbereiche parallel zu der ersten Trennlinie (T₁₀) angeordnet sind.

7. Rohmodul nach dem vorhergehenden Anspruch, wobei die Trennbereiche (10, 11) in einem regelmäßigen Abstand d₂ angeordnet sind und der Abstand d₂ 10 mm bis 500 mm beträgt, bevorzugt 50 mm bis 300 mm.

8. Rohmodul nach den vorhergehenden Ansprüchen, wobei der Abstand des ersten (10a, 11a) und zweiten (10b, 11 b) Isolierungsgrabens eines Trennbereiches (10, 11) jeweils 0,5 mm bis 100 mm und bevorzugt 4 mm bis 50 mm beträgt.

9. Rohmodul nach dem vorhergehenden Anspruch, wobei der erste (10a, 11a) und zweite Isolierungsgraben (10b, 11b) eines Trennbereiches jeweils den gleichen Abstand d₁ aufweisen.

10. Rohmodul nach dem vorhergehenden Anspruch, wobei das Verhältnis von d₂ zu d₁ von 2 bis 50 und bevorzugt von 10 bis 30 beträgt.

11. Rohmodul nach den vorhergehenden Ansprüchen, welches Transparenzöffnungen in Form von Aussparungen in der Rückelektrodenschicht (6) und der Halbleiterschicht (5) aufweist, so dass ein Teil des auf das Rohmodul fallenden Lichtes durch die Transparenzöffnungen transmittiert werden kann.

12. Rohmodul nach dem vorhergehenden Anspruch, wobei die Transparenzöffnungen in Form von parallelen Transparenzgräben (20) ausgebildet sind, welche in der Verschaltungsrichtung R verlaufen und in einem regelmäßigen Abstand d₃ angeordnet sind.

13. Rohmodul nach Anspruch 7 und 12, wobei der Abstand des ersten (10a, 11a) und zweiten (10b, 11 b) Isolierungsgrabens eines Trennbereiches d₂ einem Vielfachen des Abstandes der Transparenzgräben d₃ entspricht und der erste (10a, 11a) und zweite Isolierungsgraben (10b, 11 b) eines Trennbereiches jeweils innerhalb eines Transparenzgrabens angeordnet sind.

14. Rohmodul nach Anspruch 7 und 12, wobei der Abstand d₂ dem doppelten Wert des Abstandes d₃ entspricht.

15. Rohmodul nach den vorhergehenden Ansprüchen, welches ferner komplementäre Transparenzgräben in Form von Aussparungen in der Rückelektrodenschicht (6) und der Halbleiterschicht (5) aufweist, welche senkrecht zur Verschaltungsrichtung verlaufen und jeweils im Übergangsbereich zwischen zwei serienverschalteten Teilzellen ausgebildet sind.

16. Rohmodul nach den vorhergehenden Ansprüchen, wobei das Rohmodul (1) Kontaktierungsbereiche auf der ersten (8) und letzten (9) serienverschalteten Teilzelle eines jeden Teilbereiches (15, 16, 17, 18, 19) aufweist.

17. Dünnschichtsolarmodul umfassend ein erstes Rohmodul (1a) gemäß zumindest einem der Ansprüche 1 bis 16.

18. Dünnschichtsolarmodul gemäß Anspruch 17, ferner umfassend zumindest ein erstes Teilmodul (1 b) eines weiteren Rohmoduls gemäß den Ansprüchen 1 bis 16, wobei das erste Teilmodul (1 b) durch Auftrennen des weiteren Rohmoduls entlang einer Trennlinie erhalten werden kann, und wobei das erste Rohmodul (1a) ein Teilmodul aufweist, welches baugleich mit dem ersten Teilmodul (1 b) ausgebildet ist.

19. Dünnschichtsolarmodul nach Anspruch 18, wobei das erste Rohmodul (1a) und das erste Teilmodul (1 b) so nebeneinander angeordnet sind, dass der optische Eindruck eines einzigen Rohmoduls entsteht, welches eine größere Fläche als das erste Rohmodul (1a) aufweist.

20. Dünnschichtsolarmodul nach Anspruch 18 bis 19, umfassend ferner metallische Kontaktierungsstreifen, wobei die Kontaktierungsbereiche (8, 9) der Bereiche (15, 16, 17, 18, 19) des ersten Rohmoduls (1a) innerhalb der umlaufenden Isolierungslinie (7) und die Kontaktierungsbereiche (8a, 9a) der Bereiche (18a, 19a) des ersten Teilmoduls innerhalb der umlaufenden Isolierungslinie (7a) und innerhalb der Trennlinie (T₁₀) durch eine elektrisch leitfähige Verbindung dem Kontaktierungsstreifen kontaktiert sind und die Bereiche außerhalb des umlaufenden Isolierungsgrabens (7, 7a) und der Trennlinie nicht kontaktiert sind, wodurch die Randbereiche von erstem Rohmodul und erstem Teilmodul als isolierende Randstreifen wirken.
